# FASCICULE DE BREVET EUROPEEN

(11) **EP 0 648 018 B1**
(45) Date de publication et mention de la délivrance du brevet: **01.07.1998**
(21) Numéro de dépôt: 94410085.8
(22) Date de dépôt: 10.10.1994
(51) Int. Cl.: H03K 5/26, G06F 1/10

(54) **Circuit d'indication de relation de phase entre plusieurs signaux de même fréquence et son application à un circuit d'ajustage des déphasages entre ces signaux**
Schaltung zur Anzeige der Phasenverhältnisse zwischen mehreren Signalen mit gleicher Frequenz und ihre Anwendung in einer Schaltung zur Korrektur der Phasen zwischen diesen Signalen
Circuit indicating the phase relations between plural signals of the same frequency and its application in a circuit for adjusting the phase differences between these signals

(30) Priorité: 11.10.1993 FR 9312452
(43) Date de publication de la demande: 12.04.1995
(73) Titulaire: SGS-THOMSON MICROELECTRONICS S.A., 94250 Gentilly (FR)
(72) Inventeur: Schoellkopf, Jean-Pierre, F-38000 Grenoble (FR)
(74) Mandataire: de Beaumont, Michel

(56) Documents cités:
- US-A- 4 639 615
- US-A- 5 036 230
- IBM TECHNICAL DISCLOSURE BULLETIN, vol.30, no.11, Avril 1988, ARMONK, US pages 394 - 396 'Low-Cost Clock Generation Circuit.'

## Description

La présente invention concerne les circuits électroniques dont divers éléments nécessitent l'utilisation d'une horloge distribuée sous la forme de plusieurs signaux d'horloge de même fréquence et normalement de même phase, et concerne plus particulièrement un circuit permettant d'éviter que les déphasages entre ces signaux d'horloge soient trop importants.

Un grand nombre de circuits comprennent des éléments, tels que des bascules, des compteurs etc. qui doivent être synchronisés sur un signal d'horloge commun. Sur une puce de circuit intégré, divers éléments à synchroniser sont éparpillés, de manière que le signal d'horloge est amené à ces éléments par des liaisons de longueurs distinctes dont certaines sont relativement longues par rapport à d'autres. Sur une puce de circuit intégré, la capacité d'une liaison croit avec sa longueur. Une liaison d'horloge est en général commandée par un amplificateur délivrant un courant maximal déterminé par la taille de ses transistors. Ainsi, la pente des fronts d'un signal d'horloge délivré sur une ligne croit avec le courant maximal de l'amplificateur et diminue avec la longueur de la ligne (la capacité de la ligne). Un signal d'horloge est supposé présenter des fronts raides. Par conséquent, si la longueur des lignes d'horloge est importante, il faut accroître le courant de sortie des amplificateurs. Toutefois, si l'on accroit le courant dans une ligne au-delà d'une certaine limite, il faut également accroître la section de la ligne, car elle risquerait sinon de se détériorer à long terme. L'accroissement de section d'une ligne ne peut, en général, être obtenu qu'en augmentant la largeur des conducteurs sur la puce. Cette augmentation de largeur est limitée et souvent incompatible avec un grand nombre de systèmes de conception de circuits intégrés car elle entraine, outre une augmentation de surface de la puce, des problèmes de placement et de routage des éléments de la puce.

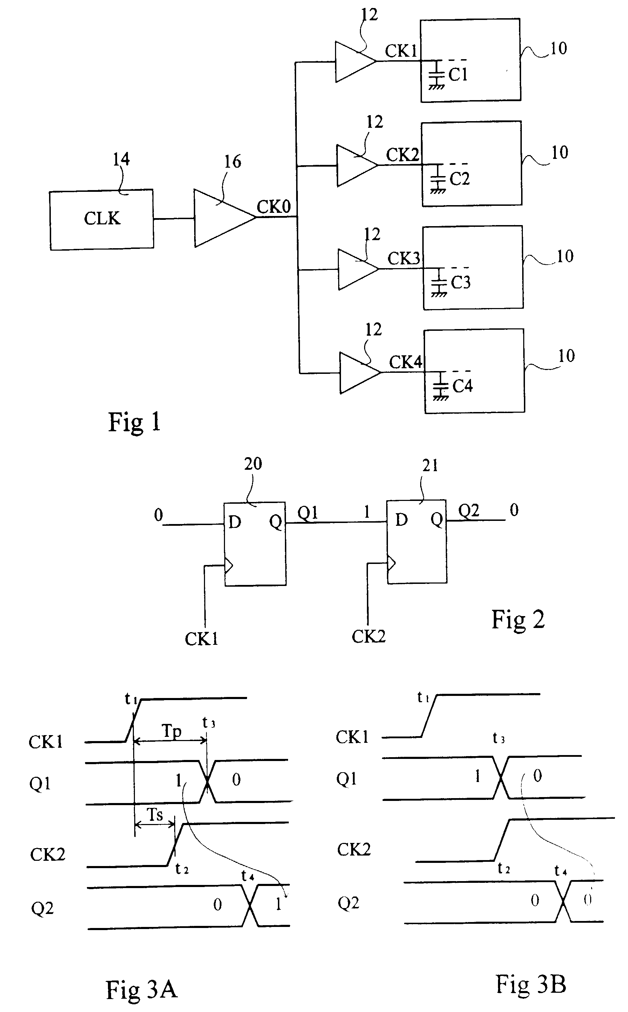

La figure 1 représente une solution couramment adoptée pour distribuer une horloge sur une puce de circuit intégré. Les éléments du circuit intégré sont regroupés en plusieurs zones 10 de forme ramassée (rectangulaire proche du carré), de manière que les liaisons à l'intérieur de ces zones présentent une longueur maximale réduite. A chaque zone 10 est fourni un signal d'horloge distinct CK1, CK2... par l'intermédiaire d'un amplificateur de courant 12 respectif. Les amplificateurs 12 reçoivent tous un signal d'horloge global CK0 fourni par un générateur d'horloge 14 par l'intermédiaire d'un amplificateur 16.

Avec oette configuration, chaque signal d'horloge CK1, CK2... est fourni à une ligne de longueur réduite. Par conséquent, pour obtenir des fronts de raideur acceptable des signaux d'horloge, il n'est pas nécessaire d'alimenter ces lignes d'horloge avec un courant trop important nécessitant l'augmentation de leur section.

Toutefois, les lignes CK1, CK2 etc. sont généralement de longueurs différentes, et présentent ainsi des capacités différentes. Les amplificateurs 12 étant sensiblement de mêmes caractéristiques, on obtient des fronts de pentes différentes sur les lignes d'horloge. Ces différentes pentes correspondent à des déphasages (skew) entre les signaux d'horloge. Comme on le verra ci-après, un déphasage trop important entre deux signaux d'horloge peut s'avérer néfaste.

Pour réduire les déphasages, il est possible de rallonger les lignes d'horloge les plus courtes. Toutefois, cette méthode, outre le fait qu'elle rend plus difficile la conception des circuits intégrés et qu'elle augmente la surface, fournit des résultats aléatoires qui dépendent de la technologie utilisée pour fabriquer le circuit intégré.

En conséquence, même si l'on prend certaines précautions, il subsistera toujours des déphasages entre les différents signaux d'horloge.

Des circuits particulièrement sensibles aux déphasages entre les signaux d'horloge sont les registres à décalage, dans le cas où des bascules de ces registres à décalage se trouvent dans des zones 10 différentes, c'est-à-dire qu'elles sont validées par des signaux d'horloge différents.

La figure 2 représente deux bascules 20 et 21 de type D connectées selon une configuration de registre à décalage. La bascule 20 est validée, par exemple, par le signal d'horloge CK1 et reçoit un signal à décaler, provenant par exemple d'une bascule précédente, sur une entrée D. La bascule 21 est validée par le signal d'horloge CK2, par exemple, et reçoit sur son entrée D la sortie Q1 de la bascule 20. On considère ci-après l'exemple où l'entrée D de la bascule 20 est à 0 et les sorties Q1 et Q2 respectivement à 1 et à 0.

En fonctionnement normal, le 0 à l'entrée de la bascule 20 est transmis sur la sortie Q1 et le 1 de la sortie Q1 est transmis sur la sortie Q2 dès la survenue pratiquement simultanée de deux fronts montants des signaux CK1 et CK2.

La figure 3A représente un chronogramme illustrant un fonctionnement normal du registre à décalage de la figure 2, dans le pire cas où le signal d'horloge CK1 est en avance de phase par rapport au signal d'horloge CK2, d'une durée Ts.

A un instant t₁, survient un front montant du signal d'horloge CK1. L'entrée D de la bascule 20 est à 0, la sortie Q1 de cette bascule est à 1 et la sortie Q2 de la bascule 21 est à 0. La bascule 20 répond à ce front avec un certain retard Tp appelé temps de propagation de la bascule. Ainsi, à un instant t₃=t₁+Tp, la sortie Q1 bascule à 0, l'état présent à l'entrée D de la bascule 20 à l'instant t₁.

Entre temps, à un instant t₂=t₁+Ts, survient un front montant du signal d'horloge CK2. Comme pour la bascule 20, la sortie Q2 de la bascule 21 change en retard à un instant t₄=t₂+Tp. La sortie Q2 de la bascule 21 passe à 1, l'état présent à l'entrée de la bascule 21 à l'instant t₂.

Une bascule présente ce que l'on appelle un temps de maintien Th qui correspond au temps minimal pendant lequel un état doit être maintenu à l'entrée de la bascule après son instant de validation pour que cette valeur soit effectivement prise en compte (transférée à la sortie de la bascule). Si ce temps de maintien Th n'est pas respecté, la bascule fonctionne de manière erronée. Dans l'exemple de la figure 3A, le temps de maintien Th de la bascule 21 est supposé respecté, c'est-à-dire que l'on a Ts < Tp-Th.

La figure 3B représente un cas de fonctionnement erroné. Par rapport au cas de la figure 3A, le déphasage Ts entre les signaux CK1 et CK2 est augmenté, de manière que l'on a Ts > Tp-Th. A l'instant t₄, la sortie Q2 bascule à l'état que prend la sortie Q1 après l'instant t₃, c'est-à-dire reste à 0 au lieu de basculer à 1 ; l'état 1 est perdu.

Un objet de la présente invention est de prévoir un circuit permettant, de manière automatique, de réduire les déphasages entre plusieurs signaux d'horloge.

Pour atteindre cet objet, la présente invention prévoit premièrement un circuit d'indication du signal ayant le retard maximal ou le retard minimal parmi n signaux, comprenant n(n-1)/2 bascules, associées chacune à un couple différent de signaux, un premier signal de chaque couple étant appliqué sur une entrée de mise à 0 de la bascule et causant la mise à 0 lors de son activation, et un deuxième signal de chaque couple étant appliqué sur une entrée de mise à 1 et causant la mise à 1 lors de son activation. Des portes logiques fournissant des indications associées respectivement à chaque signal considéré, sont connectées en sortie des bascules pour indiquer que le signal considéré est celui ayant le retard maximal ou le retard minimal quand les bascules associées à tous les couples de signaux incluant le signal considéré sont à des états respectifs adéquats après l'activation du signal ayant le retard maximal.

Selon un mode de réalisation de la présente invention, le circuit comprend une porte associée à un signal considéré, qui est active quand les bascules associées aux couples de signaux, dont le signal considéré est le premier signal, sont à un premier état, et les bascules associées aux couples, dont le signal considéré est le deuxième signal, sont à un deuxième état, opposé au premier.

Selon un mode de réalisation de la présente invention, lesdits signaux sont des signaux périodiques de même fréquence, les états desdites portes étant fournis à des bascules d'un registre validé quand lesdits signaux sont tous à un état actif.

Pour réduire les déphasages, il est prévu, selon l'invention, un circuit d'ajustement des déphasages entre plusieurs signaux d'horloge de même fréquence délivrés respectivement par des amplificateurs. Les impédances de sortie des amplificateurs sont réglables et le circuit comprend le circuit d'indication susmentionné pour indiquer le signal d'horloge à retard de phase maximal, et un circuit de commande de l'accroissement des impédances de sortie des amplificateurs associés aux signaux d'horloge autres que le signal d'horloge à retard de phase maximal.

Selon un mode de réalisation de la présente invention, le circuit de commande comprend des moyens d'augmentation par paliers de l'impédance d'un amplificateur associé à un signal en avance de phase jusqu'au basculement de l'état de la bascule associée au couple de signaux incluant le signal à retard de phase maximal et ledit signal en avance de phase.

Selon un mode de réalisation de la présente invention, chaque amplificateur comprend une pluralité d'inverseurs pouvant être individuellement connectés en parallèle ou non sur un premier inverseur, en fonction de l'état d'un registre dont le contenu est modifié par des impulsions successives fournies par le circuit de commande.

Ces objets, caractéristiques et avantages ainsi que d'autres de la présente invention seront exposés en détail dans la description suivante de modes de réalisation particuliers faite à titre non limitatif à l'aide des figures jointes parmi lesquelles :
la figure 1, précédemment décrite, représente un réseau classique de distribution d'une horloge dans un circuit électronique ;
la figure 2 représente un registre à décalage classique ;
les figures 3A et 3B représentent des chronogrammes illustrant un bon et un mauvais fonctionnement du registre à décalage de la figure 2 ;
La figure 4A représente un mode de réalisation simplifié d'un circuit selon l'invention d'indication du signal ayant le déphasage minimal (ou maximal) entre deux signaux d'horloge ;
la figure 4B représente un chronogramme du fonctionnement du circuit de la figure 4A ;
la figure 5 représente un mode de réalisation de circuit d'indication selon la présente invention adapté à traiter quatre signaux d'horloge ;
la figure 6 représente un mode de réalisation de circuit d'ajustement des déphasages entre plusieurs signaux d'horloge selon la présente invention ;
la figure 7 représente plus en détail un élément du circuit de la figure 6 ; et
la figure 8 représente plus en détail un autre élément du circuit de la figure 6.

La présente invention vise à ajuster à une valeur minimale les déphasages entre des signaux d'horloge, de manière à éviter qu'un déphasage trop important entre deux des signaux provoque un mauvais fonctionnement de bascules ou autres éléments d'un circuit. Pour cela, on prévoit d'abord un circuit permettant de fournir des indications sur les relations de phase entre les signaux d'horloge. Un aspect de la présente invention est de prévoir un tel circuit.

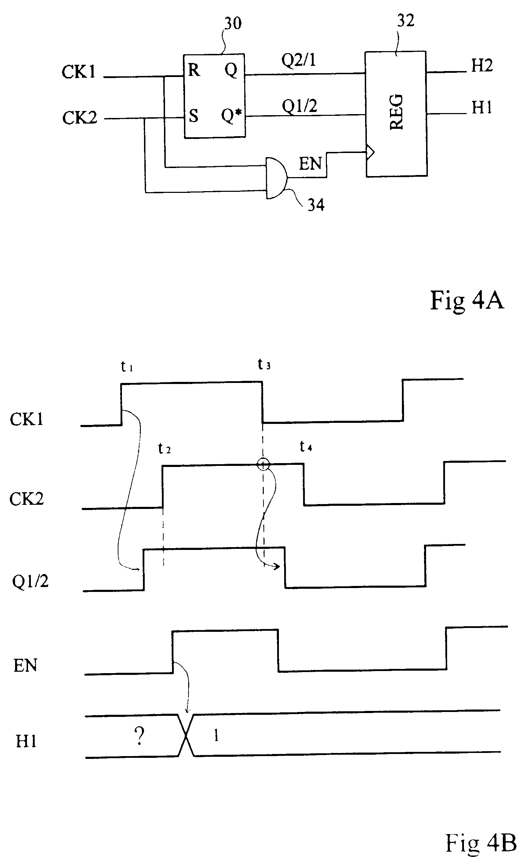

La figure 4A est destinée à illustrer, à l'aide d'un exemple simplifié à deux signaux d'horloge CK1 et CK2, le principe d'un circuit permettant de fournir une indication de relation de phase. Ce circuit comprend une bascule RS 30 recevant sur une entrée de "mise à 0" R le signal d'horloge CK1 et sur une entrée de "mise à 1" S le signal d'horloge CK2.

Lorsque un 1 est présent sur l'entrée S et un 0 sur l'entrée R, une sortie directe Q de la bascule est mise à 1 et une sortie inversée Q* à 0. Lorsque un 1 est présent sur l'entrée R et un 0 sur l'entrée S, la sortie directe Q est mise à 0 et la sortie inversée Q* à 1. Lorsque les états sur les entrées R et S sont identiques, la bascule conserve son état. Le signal sur la sortie directe Q est noté Q2/1 et le signal sur la sortie inversée Q* est notée Q1/2.

Avec cette configuration, la sortie Q1/2 indique en basculant à 1 après un front montant du signal CK1, que le signal CK1 est en avance de phase par rapport au signal CK2. La sortie Q2/1 est l'inverse logique de la sortie Q1/2, et indique, si elle bascule à 1 après un front montant du signal CK2, que le signal CK2 est en avance de phase par rapport au signal CK1. Les sorties Q2/1 et Q1/2 sont stockées dans un registre 32 afin de fournir de manière continue la relation de phase entre les horloges CK1 et CK2. Le registre 32 est validé par la sortie EN d'une porte ET 34 recevant les signaux CK1 et CK2. Les sorties Q1/2 et Q2/1 stockées dans le registre 32 sont désignées respectivement par les références H1 et H2.

La figure 4B représente un chronogramme du fonctionnement du circuit de la figure 4A.

A un instant t1, survient un front montant du signal CK1 qui est en avanoe de phase par rapport au signal CK2. Les signaux CK2, Q1/2, et EN sont à 0. Le signal H1 est à un état quelconque. Ce front montant du signal CK1 provoque, après un délai de propagation, le basculement à 1 de la sortie Q1/2 (et le basculement à 0 de la sortie Q2/1).

A un instant t2 ultérieur survient un front montant du signal CK2. Le signal CK1 est toujours à 1 ; la sortie EN de la porte ET 34 passe à 1, ce qui entraîne la validation du registre 32. La sortie Q1/2, à 1, est mémorisée dans le registre 32 ; le signal H1 passe à 1 (et le signal H2 à 0).

A un instant t3, survient un front descendant du signal CK1 mais le signal CK2 est toujours à 1 ; la sortie Q1/2 passe à 0 peu de temps après l'instant t3. Ce passage à 0 de la sortie Q1/2 n'affecte pas le signal H1 dont l'état reste mémorisé dans le registre 32.

A un instant t4 survient un front descendant du signal CK2.

Tant que le signal CK1 est en avance de phase par rapport au signal CK2, le signal H1 reste à 1 pour indiquer cette relation de phase de manière continue. Similairement, le signal H2 reste à 0 pour indiquer que le signal CK2 est en retard de phase par rapport au signal CK1. Si au cours du temps, la relation de phase entre les signaux CK1 et CK2 s'inverse, les états des signaux H1 et H2 s'inversent, de la manière décrite pour l'instant t2, pour indiquer cette nouvelle relation de phase.

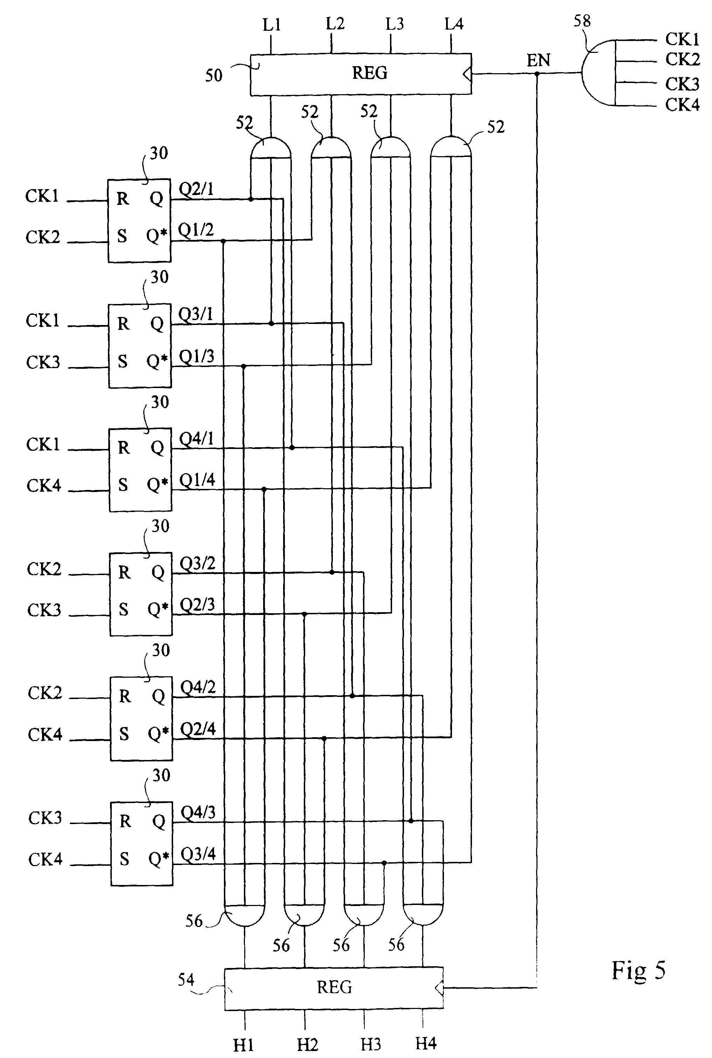

La figure 5 représente un mode de réalisation de circuit permettant d'indiquer, parmi n signaux d'horloge CK1 à CKn, les deux signaux ayant respectivement le retard maximal et le retard minimal. L'exemple représenté correspond à n=4.

Le circuit nécessite au moins n(n-1)/2 bascules RS 30, associées chacune à un couple de signaux d'horloge CKi, CKj, où i, j = 1, 2,... n et i<j. Une bascule 30 recevant sur son entrée de mise à 0 R un signal CKi et sur son entrée de mise à 1 S un signal CKj fournit sur sa sortie directe un signal Qj/i, et sur sa sortie inversée un signal Qi/j. Un signal Qi/j indique en basculant à 1 après un front montant du signal CKi, que le signal CKi est en avance de phase par rapport au signal CKj. En mémorisant les couples de sorties Qi/j, Qj/i comme cela est fait pour le couple Q1/2, Q2/1 à la figure 4A, on obtient toutes les indications possibles de relation de phase.

Le circuit est en outre prévu pour indiquer sur des lignes L1 à Ln le signal d'horloge ayant le retard de phase maximal par rapport aux autres et sur des lignes H1 à Hn le signal d'horloge ayant l'avance de phase maximale par rapport aux autres. Plus précisément, une ligne Lp (p=1, 2,... n) à 1 indique que le signal d'horloge CKp est celui ayant le retard de phase maximal, et une ligne Hq (q=1, 2,... n) à 1 indique que le signal d'horloge CKq est celui ayant l'avance de phase maximale.

Pour cela, un signal Lp correspond à la sortie, périodiquement mémorisée dans un registre 50, d'une porte ET respective 52 recevant chaque sortie Qj/p (j=1, 2,... n et j≠p) des bascules 30. Ainsi, le signal Lp est activé lorsque chaque bascule 30 recevant le signal d'horloge CKp indique par une de ses sorties Q que le signal CKp est en retard de phase par rapport à l'autre signal d'horloge que reçoit la bascule.

Un signal Hq correspond à la sortie, mémorisée périodiquement dans un registre 54, d'une porte ET respective 56 recevant chaque sortie Qq/j (j=1, 2,... n et j≠q) des bascules 30. Ainsi, un signal Hq est activé lorsque chaque bascule 30 recevant le signal d'horloge CKq indique par une de ses sorties Q que le signal d'horloge CKq est en avance de phase par rapport à l'autre signal d'horloge que reçoit la bascule.

Les registres 50 et 54 sont validés après chaque dernier front montant des signaux CK1 à CKn, par exemple par la sortie EN d'une porte ET 58 recevant les signaux CK1 à CKn.

De nombreuses variantes et modifications du circuit d'indication de la figure 5 apparaîtront à l'homme du métier. On peut utiliser une seule sortie Q des bascules 30, par exemple celle reliée aux portes ET 52, les portes ET 56 étant remplacées par des portes NON OU recevant les mêmes signaux que les portes ET 52...

Le circuit d'indication de la figure 5 présente de nombreuses applications autres que celles qui seront décrites ci-après. Il peut être utilisé avec n'importe quel ensemble de signaux présentant une certaine répétitivité de variation dans le temps et qui sont tels que le front actif du signal le plus en retard se produit avant un front inactif du signal le plus en avance. Le circuit peut, par exemple, servir à détecter la première requête parmi un ensemble de requêtes de même priorité arrivant à un microprocesseur. En utilisant des multiplexeurs adéquatement commandés par les signaux L1 à Ln et H1 à Hn, le circuit peut fournir le signal d'horloge ayant l'avance de phase maximale et/ou le signal d'horloge ayant le retard de phase maximal.

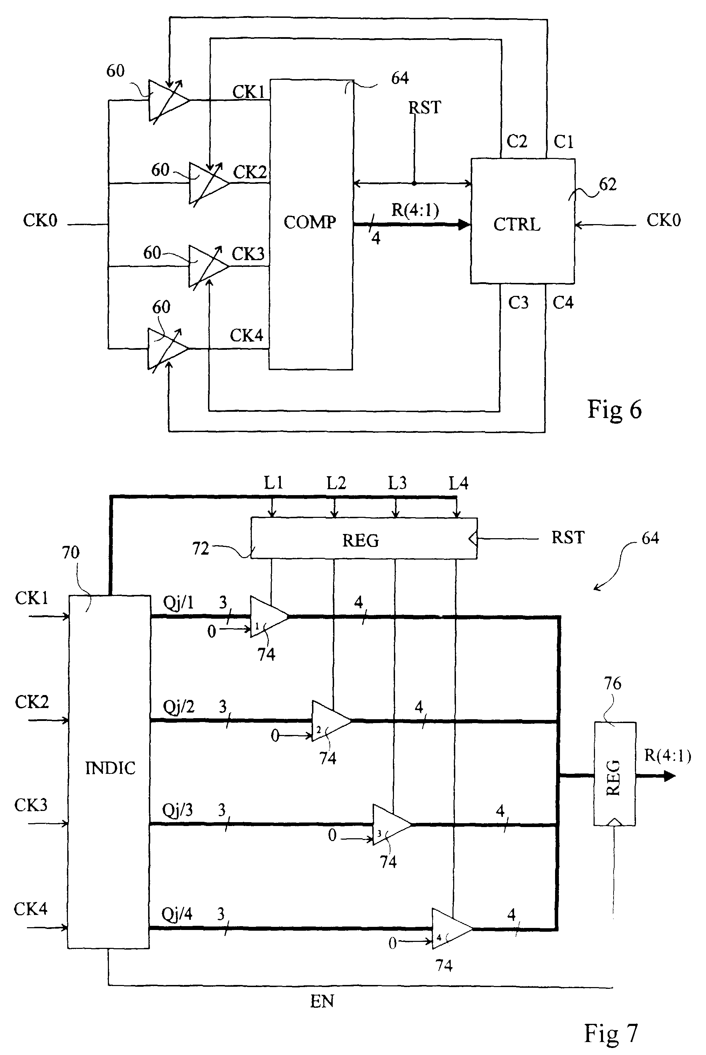

La figure 6 représente un mode de réalisation de circuit selon l'invention permettant d'ajuster les déphasages entre les signaux d'horloge CKl à CKn à une valeur minimale. Ce circuit est prévu pour détecter le signal d'horloge ayant le retard de phase maximal et augmenter les impédances de sortie des amplificateurs (figure 1) fournissant les autres signaux d'horloge, de manière à amener les phases de ces autres signaux d'horloge à une valeur proche du retard maximal. En effet, en augmentant l'impédance d'un amplificateur, on diminue la pente des fronts du signal d'horloge qu'il fournit, ce qui correspond à augmenter le retard de phase de ce signal d'horloge.

Chacun des signaux d'horloge CK1 à CKn est délivré par un amplificateur 60 respectif à impédance de sortie ajustable. Les amplificateurs 60, comme dans la figure 1, reçoivent un signal d'horloge commun CK0. Les impédances de sortie des amplificateurs 60 sont réglées par des signaux respectifs C1 à Cn délivrés par un circuit de commande 62 prenant en compte les états de n lignes R1 à Rn. Ce circuit de commande est cadencé par le signal d'horloge global CK0, par exemple. Les états des lignes R constituent le résultat fourni par un circuit de comparaison 64 recevant les signaux d'horloge CK1 à CKn. Ce circuit de comparaison 64, dont un mode de réalisation est décrit ci-après en relation avec la figure 7, et le circuit de commande 62 reçoivent un signal d'initialisation RST.

Les résultats R fournis par le circuit de comparaison 64 sont établis de la manière suivante, à la suite d'une initialisation RST. Une ligne Rp (p=1, 2,... n) est mise à 0 lorsque le signal CKp est celui qui a le retard de phase maximal. Les autres lignes Rj (j=1, 2,... n et j≠p) indiquent par un état 1 que les signaux CKj sont en avance de phase par rapport au signal CKp.

Le circuit de commande 62 est prévu pour accroître progressivement l'impédance de sortie de l'amplificateur 60 associé à chaque signal CKj jusqu'à ce que la ligne Rj bascule à 0, indiquant alors que le signal d'horloge CKj est en retard de phase par rapport au signal d'horloge CKp.

Selon un mode de réalisation, décrit plus en détail ultérieurement, les impédances des amplificateurs 60 sont augmentées par pas successifs après qu'elles sont initialisées, par le signal RST, à leurs valeurs minimales. Le circuit de commande 62, pour augmenter une impédance par pas, fournit autant d'impulsions que de pas sur la ligne de commande C (C1 à Cn) adéquate. Un tel circuit de commande peut facilement être réalisé par l'homme du métier à l'aide de portes logiques. Chaque signal Ci, par exemple, est fourni par une porte ET recevant le signal Ri et le signal d'horloge CK0.

A la fin d'une phase d'ajustement, lorsque toutes les lignes R sont à 0, les signaux d'horloge qui étaient en avance de phase par rapport au signal CKp sont tous en retard de phase, par rapport au signal CKp. Une telle phase d'ajustement est effectuée à chaque activation du signal d'initialisation RST. Ce signal est activé à la mise sous tension du circuit, par exemple, ou bien périodiquement.

La figure 7 représente un mode de réalisation de circuit de comparaison 64. Ce circuit comprend un circuit d'indication 70 tel que celui décrit en relation avec la figure 5. Les lignes L1 à Ln, indiquant le signal d'horloge ayant le retard de phase maximal, sont fournis à un registre 72 validé par le signal RST. Le bit du registre 72 qui correspond à une ligne Lp (p=1, 2,... n) commande une porte trois états 74 respective à n canaux de rangs 1 à n correspondant respectivement aux rangs 1 à n des lignes de résultat R. Le canal de rang p de la porte trois états 74 associée à la ligne Lp reçoit la valeur 0 et les canaux de rangs j (j=1, 2,... n et j≠p) reçoivent respectivement les sorties Qj/p des bascules 30 du circuit d'indication 70. Les sorties des portes trois états 74 sont fusionnées en n lignes reliées à l'entrée d'un registre 76. Ce registre 76 est validé par le signal EN fourni par le circuit d'indication 70 et contient le résultat R susmentionné.

Avec cette configuration, lorsqu'une ligne Lp est active, la ligne de résultat Rp est à 0 et chaque autre ligne de résultat Rj est mise à l'état de la sortie Qj/p qui indique que le signal CKj est en avance de phase ou non par rapport au signal CKp.

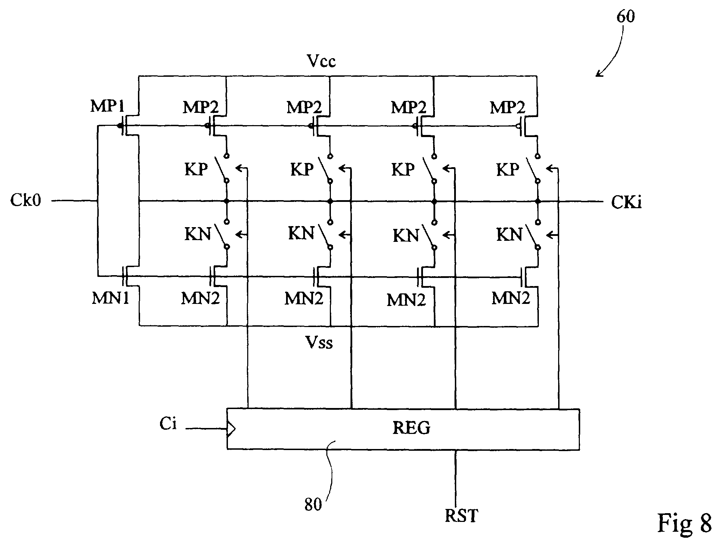

La figure 8 représente un mode de réalisation d'amplificateur 60 à impédance de sortie ajustable fournissant un signal d'horloge CKi. Cet amplificateur comprend un premier inverseur constitué d'un transistor MOS à canal P MP1 et d'un transistor MOS à canal N MN1 dont les sources sont reliés respectivement à un potentiel haut Vcc et à un potentiel bas Vss, dont les drains sont reliées ensemble pour former la sortie de l'inverseur, et dont les grilles sont reliées ensemble pour former l'entrée de l'inverseur, recevant le signal CK0.

Il est prévu une pluralité d'inverseurs supplémentaires, formés de transistors MOS à canal P MP2 et de transistors MOS à canal N MN2, pouvant être connectés en parallèle sur l'inverseur MP1/MN1 ou bien déconnectés. Les sources des transistors MP2 sont reliées au potentiel Vcc et les sources des transistors MN2 sont reliées au potentiel Vss. Les drains des transistors MP2 et MN2 sont reliés à la sortie d'horloge CKi par des interrupteurs KP et KN respectivement. Les deux interrupteurs KP et KN de chaque inverseur MP2/MN2 sont commandés par un bit respectif d'un registre 80. Le registre 80 est configuré soit en registre à décalage, soit en compteur. Le contenu du registre 80 est initialisé par le signal RST de manière que tous les inverseurs MP2/MN2 soient connectés en parallèle sur l'inverseur MP1/MN1, c'est-à-dire de manière que l'impédance de sortie de l'amplificateur 60 soit minimale.

Si le registre 80 est un registre à décalage, les transistors MP2 sont tous de même taille et les transistors MN2 de même. Pour diminuer progressivement l'impédance de sortie de l'amplificateur, des impulsions successives du signal de commande Ci introduisent des 1 successifs dans le registre à décalage 80, de manière à déconnecter un inverseur MP2/MN2 à chaque impulsion.

Si le registre 80 est un compteur, celui-ci est incrémenté successivement par des impulsions du signal de commande Ci. Dans ce cas, les transistors de l'inverseur MP2/MN2 associé au bit de rang 0 du registre 80 ont une surface donnée et les transistors d'un inverseur MP2/MN2 associé au bit de rang i du registre 80 ont une surface 2ⁱ fois supérieure. Cette solution permet d'obtenir un grand nombre de pas de variation de l'impédance de sortie de l'amplificateur 60 à l'aide d'un faible nombre d'inverseurs et d'un registre à faible nombre de bits.

De nombreuses variantes et modifications de la présente invention apparaîtront à l'homme du métier. Par exemple, les états actifs des signaux, décrits comme étant 1, peuvent être inversés ; l'homme du métier saura alors adopter des circuits logiques de traitement adéquats.

## Revendications

1. Circuit d'indication du signal ayant le retard maximal ou le retard minimal parmi n signaux (CK1 à CKn), caractérisé en ce qu'il comprend :
- n(n-1)/2 bascules (30), associées chacune à un couple différent de signaux (CKi, CKj), un premier signal (CKi) de chaque couple étant appliqué sur une entrée de mise à 0 de la bascule et causant la mise à 0 lors de son activation, et un deuxième signal (CKj) de chaque couple étant appliqué sur une entrée de mise à 1 et causant la mise à 1 lors de son activation ; et
- des portes logiques (52, 56) fournissant des indications associées respectivement à chaque signal considéré (CKp), connectées en sortie des bascules pour indiquer que le signal considéré est celui ayant le retard maximal ou le retard minimal quand les bascules associées à tous les couples de signaux (CKp, CKj) incluant le signal considéré sont à des états respectifs adéquats après l'activation du signal ayant le retard maximal.

2. Circuit d'indication selon la revendication 1, caractérisé en ce qu'une porte (52, 56) associée à un signal considéré (CKp) est active quand les bascules associées aux couples de signaux (CKp, CKj), dont le signal considéré est le premier signal, sont à un premier état, et les bascules associées aux couples (CKj, CKp), dont le signal considéré est le deuxième signal, sont à un deuxième état, opposé au premier.

3. Circuit d'indication selon la revendication 1, caractérisé en ce que lesdits signaux sont des signaux périodiques de même fréquence, les états desdites portes (52, 56) étant fournis à des bascules d'un registre (50, 54) validé quand lesdits signaux sont tous à un état actif.

4. Circuit d'ajustement des déphasages entre plusieurs signaux d'horloge (CK1 à CKn) de même fréquence délivrés respectivement par des amplificateurs (60), caractérisé en ce que les impédances de sortie des amplificateurs sont réglables et en ce que le circuit comprend :
- un circuit d'indication (70) selon la revendication 1, pour indiquer le signal d'horloge à retard de phase maximal ; et
- des moyens (62) de commande de l'accroissement des impédances de sortie des amplificateurs (60) associés aux signaux d'horloge autres que le signal d'horloge à retard de phase maximal.

5. Circuit d'ajustement selon la revendication 4, caractérisé en ce que lesdits moyens de commande comprennent des moyens (80) d'augmentation par paliers de l'impédance d'un amplificateur associé à un signal en avance de phase jusqu'au basculement de l'état de la bascule (30) associée au couple de signaux incluant le signal à retard de phase maximal et ledit signal en avance de phase.

6. Circuit d'ajustement selon la revendication 5, caractérisé en ce que chaque amplificateur (60) comprend une pluralité d'inverseurs (MP2/MN2) pouvant être individuellement connectés en parallèle ou non sur un premier inverseur (MP1/ MN1), en fonction de l'état d'un registre (80) dont le contenu est modifié par des impulsions successives (C) fournies par les moyens de commande (62).

## Patentansprüche

1. Schaltung zum Angeben des Signals, das unter n Signalen (CK1-CKn) die maximale Verzögerung oder die minimale Verzögerung hat, **gekennzeichnet** durch n(n-1)/2 Flip-Flops (30), von denen jedes einem anderen Signalpaar (CKi, CKj) zugeordnet ist, wobei ein erstes Signal (CKi) jedes Paares an einen Rücksetzeingang des Flip-Flops angelegt wird und bei Aktivierung ein Zurücksetzen auf Null bewirkt, und wobei ein zweites Signal (CKj) jedes Paares an einen Setzeingang angelegt wird und bei Aktivierung ein Setzen auf Eins bewirkt; und Logikgatter (52, 56), die Angaben liefern, welche jeweils jedem betrachteten Signal (CKp) zugeordnet sind, und die mit dem Ausgang der Flip-Flops verbunden sind, um anzugeben, ob das betrachtete Signal das mit der maximalen Verzögerung oder der minimalen Verzögerung ist, wenn die allen Signalpaaren (CKi, CKj), einschließlich des betrachteten Signals, zugeordneten Flip-Flops nach der Aktivierung des Signals mit der maximalen Verzögerung jeweils geeignete Zustände haben.

2. Schaltung nach Anspruch 1, dadurch **gekennzeichnet**, daß ein Gatter (52, 56), das einem betrachteten Signal (CKp) zugeordnet ist, aktiviert wird, wenn die den Signalpaaren (CKp, CKj) zugeordneten Flip-Flops, bei denen das betrachtete Signal das erste Signal ist, in einem ersten Zustand sind und wenn die den Signalpaaren (CKj, CKp) zugeordneten Flip-Flops, bei denen das betrachtete Signal das zweite Signal ist, in einem zweiten Zustand sind, der zum ersten Zustand entgegengesetzt ist.

3. Schaltung nach Anspruch 1, bei der die Signale periodische Signale mit derselben Frequenz sind, wobei die Zustände der Gatter (52, 56) an die Flip-Flops eines gültigen Registers (50, 54) angelegt werden, wenn diese Signale alle in einem aktiven Zustand sind.

4. Schaltung zum Einstellen der Phasenverschiebung zwischen mehreren Taktsignalen (CK1-CKn), welche dieselbe Frequenz haben und jeweils von Verstärkern (60) vorgesehen werden, dadurch **gekennzeichnet**, daß die Ausgangsimpedanzen der Verstärker einstellbar sind und daß die Schaltung folgende Merkmale aufweist: eine Schaltung (70) nach Anspruch 1 zum Angeben des Taktsignals mit der maximalen Phasenverzögerung; und Mittel (62) zum Steuern der Zunahme der Ausgangsimpedanzen der Verstärker (60), die den anderen Taktsignalen als dem Taktsignal mit der maximalen Phasenverzögerung zugeordnet sind.

5. Schaltung nach Anspruch 4, dadurch **gekennzeichnet**, daß die Steuermittel (62) Mittel (80) zum schrittweisen Erhöhen der Impedanz eines Verstärkers, der einem Signal mit voreilender Phase zugeordnet ist, bis zum Schalten des Flip-Flops (30), das dem Signalpaar zugeordnet ist, welches das Signal mit der maximalen Phasenverzögerung und das Signal mit der voreilenden Phase umfaßt, aufweist.

6. Schaltung nach Anspruch 5, dadurch **gekennzeichnet**, daß jeder Verstärker (60) mehrere Inverter (MP2/MN2) aufweist, die einzeln parallel zu einem ersten Inverter (MP1/MN1) als Funktion des Zustands eines Registers (80) geschaltet sein können, dessen Inhalt durch aufeinanderfolgende Impulse (C) modifiziert wird, die von den Steuermitteln (62) geliefert werden.

## Claims

1. A circuit for indicating the signal having the maximum lag or the minimum lag among n signals (CK1-CKn), characterized in that it includes:
- n(n-1)/2 flip-flops (30) associated each with a different pair of signals (CKi, CKj), a first signal (CKi) of each pair being applied to a reset input of the flip-flop and causing a reset when activated and a second signal (CKj) of each pair being applied to a set input and causing a set when activated ; and
- logic gates (52, 56) providing indications respectively associated with each considered signal (CKp), and connected to the output of the flip-flops for indicating whether the considered signal is that having the maximum lag or the minimum lag when said flip-flops associated with all the pairs of signals (CKp, CKj) including the considered signal are at respective suitable states after the activation of the signal having the maximum lag.

2. The indication circuit of claim 1, characterized in that a gate (52, 56) associated with a considered signal (CKp) is enabled when the flip-flops associated with the signal pairs (CKp, CKj), in which the considered signal is the first signal, are in a first state, and when the flip-flops associated with the signal pairs (CKj, CKp), in which the considered signal is the second signal, are in a second state, opposite to the first state.

3. The indication circuit of claim 1, wherein the signals are periodical signals having the same frequency, the states of said gates (52, 56) being provided to flip-flops of a register (50, 54) enabled when all the signals are in an active state.

4. An adjustment circuit for adjusting the skew between several clock signals (CK1-CKn) that have the same frequency and respectively provided by amplifiers (60), wherein the output impedance of the amplifiers is adjustable, said circuit including:
- the indication circuit (70) of claim 1, for indicating the clock signal having the maximum phase lag; and
- control means (62) for controlling the increase of the output impedances of the amplifiers (60) associated with the clock signals different from the clock signal having the maximum phase lag.

5. The adjustment circuit of claim 4, wherein said control means include means (80) for incrementing the impedance of an amplifier associated with a signal in phase advance until the switching of the flip-flop (30) associated with the pair of signals including the signal having the maximum phase lag and said signal in phase advance.

6. The adjustment circuit of claim 5, wherein each amplifier (60) includes a plurality of inverters (MP2/MN2) that may be individually connected in parallel with a first inverter (MP1/MN1), depending on the state of a register (80) whose content is modified by successive pulses (C) provided by the control means (62).
